# EUROPEAN PATENT SPECIFICATION

(11) **EP 3 654 435 B1**
(45) Date of publication and mention of the grant of the patent: **22.06.2022**
(21) Application number: 19207024.1
(22) Date of filing: 05.11.2019
(51) Int. Cl.: H01M 10/052, H01M 10/0585, H01M 10/48, H01M 50/572

(54) **ALL-SOLID LITHIUM SECONDARY BATTERY, AND DETERIORATION DETERMINATION METHOD OF ALL-SOLID LITHIUM SECONDARY BATTERY**
VOLLFESTE LITHIUMSEKUNDÄRBATTERIE UND VERSCHLECHTERUNGSBESTIMMUNGSVERFAHREN EINER VOLLFESTEN LITHIUMSEKUNDÄRBATTERIE
BATTERIE SECONDAIRE AU LITHIUM ENTIÈREMENT SOLIDE ET PROCÉDÉ DE DÉTERMINATION DE LA DÉTÉRIORATION D'UNE BATTERIE SECONDAIRE AU LITHIUM ENTIÈREMENT SOLIDE

(30) Priority: 15.11.2018 JP 2018215045
(43) Date of publication of application: 20.05.2020
(73) Proprietor: TOYOTA JIDOSHA KABUSHIKI KAISHA, Toyota-shi, Aichi-ken, 471-8571 (JP)
(72) Inventor: WATANABE, Masaki, Toyota-shi, Aichi-ken, 471-8571 (JP); NOSE, Masafumi, Toyota-shi, Aichi-ken, 471-8571 (JP)
(74) Representative: Winter, Brandl - Partnerschaft mbB

(56) References cited:
- CN-U- 207 719 355
- US-A- 5 536 599
- US-A1- 2017 155 116

## Description

### 1. Field of the Invention

The present disclosure relates to an all-solid lithium secondary battery and a deterioration determination method of an all-solid lithium secondary battery.

### 2. Description of Related Art

Lithium secondary batteries have features that they have a higher energy density than other secondary batteries and can be operated at a high voltage. Thus, lithium secondary batteries are used for information devices such as mobile phones as secondary batteries that can be easily reduced in size and weight, and in recent years, the demand for large power sources for electric vehicles, hybrid vehicles and the like has increased.

Regarding lithium secondary batteries, it is known that, depending on the configuration and a manner of use of the battery, metallic lithium dendrites grow due to repeated charging and discharging and the like and reach a positive electrode active material layer from a negative electrode active material layer, which results in internal short circuiting.

Examples of techniques for restricting such internal short circuiting include WO 2015/182615, Japanese Unexamined Patent Application Publication No. 2009-301959 (JP 2009-301959 A), and Japanese Unexamined Patent Application Publication No. 2009-211910 (JP 2009-211910 A).

WO 2015/182615 discloses a secondary battery including a positive electrode active material layer, a negative electrode active material layer made of an alkali metal, a separator which is made of a tetrafluoroethylene (TFE) polymer or copolymer that reacts with an alkali metal dendrite, and in which a hydrophilization treatment is performed in a proportion of 10% or more and 80% or less, and a layer which is positioned between the separator and the negative electrode active material layer and does not react with an alkali metal dendrite.

In addition, JP 2009-301959 A discloses an all-solid lithium secondary battery having a surface vapor deposition film in which a solid electrolyte is deposited between a negative electrode active material layer and a solid electrolyte layer, and/or between a negative electrode active material layer and a solid electrolyte layer by a gas phase method.

In addition, JP 2009-211910 A discloses an all-solid lithium secondary battery in which there is a liquid substance that reacts with metallic lithium to generate an electronic insulator in a solid electrolyte layer of a powder molded article obtained by molding a solid electrolyte powder.

Here, in lithium secondary batteries, for purposes other than restricting internal short circuiting, for example, reducing the internal resistance, improving the ionic conductivity, or improving the energy density, a plurality of solid electrolyte layers and the like may be disposed between a positive electrode active material layer and a negative electrode active material layer. Examples thereof include Japanese Unexamined Patent Application Publication No. 2014-238925 (JP 2014-238925 A) and Japanese Unexamined Patent Application Publication No. 2009-259696 (JP 2009-259696 A).

JP 2014-238925 A discloses a lithium secondary battery in which a polymer solid electrolyte layer and an inorganic solid electrolyte layer are disposed between a positive electrode active material layer and a negative electrode active material layer.

In addition, JP 2009-259696 A discloses a lithium secondary battery in which an interface layer is disposed between a negative electrode active material layer and a solid electrolyte layer, and also a lithium secondary battery in which a buffer layer is disposed between a positive electrode active material layer and a solid electrolyte layer.

Furthermore, CN 207719355 U relates to the field of lithium batteries, in particular to a current collector structure. Herein, a current collector comprising two opposite main surfaces, wherein a positive electrode layer of a metal fluoride is formed on one main surface to serve as a positive electrode structure of a lithium battery cell, a negative electrode layer was formed on the other main surface to serve as a negative electrode structure of another lithium battery cell.

US 2017/155116 A1 relates to a secondary battery and a separator used therein. Herein, US 2017/155116 A1 discloses a secondary battery, comprising a positive electrode, a negative electrode comprising alkali metal, a separator comprising a layer of tetrafluoroethylene (TFE) polymer or copolymer that reacts with a dendrite of the alkali metal, the separator being hydrophilized at a rate of not less than 10% and not more than 80% and a layer that does not react with a dendrite of the alkali metal located between the separator and the negative electrode, wherein the standard deviation of opening areas of pores on the negative electrode side surface of the layer that does not react with a dendrite of the alkali metal is 0.1 µm 2 or less.

Furthermore, US 5536599 A pertains to improved electrochemical cells and more particularly to solid polymer electrolyte-based cells containing alkali metal negative electrodes (anodes), and especially lithium containing anodes. The improvement features the use of ferrocenes to provide both overcharge protection and suppression of Li dendrite growth in rechargeable solid polymer electrolyte batteries having anodes of lithium or Li-containing compounds.

### SUMMARY OF THE INVENTION

As described above, as disclosed in, for example, WO 2015/182615, JP 2009-301959 A, and JP 2009-211910 A, lithium secondary batteries that restrict internal short circuiting by restricting growth of metallic lithium dendrites are known.

However, in these lithium secondary batteries, when restriction of growth of metallic lithium dendrites is not sufficient, if charging and discharging are repeated, metallic lithium dendrites will eventually reach the positive electrode active material layer, and internal short circuiting can be caused.

In such a case, it is difficult to detect deterioration of a lithium secondary battery due to growth of metallic lithium dendrites until the metallic lithium dendrites reach the positive electrode active material layer and internal short circuiting occurs.

The present disclosure provides an all-solid lithium secondary battery that can restrict internal short circuiting and detect whether the all-solid lithium secondary battery has deteriorated before internal short circuiting occurs, and a method of detecting whether an all-solid lithium secondary battery has deteriorated.

A first aspect of the present invention relates to an all-solid lithium secondary battery including a positive electrode active material layer, a metallic lithium absorption layer containing a metallic lithium reactive substance that reacts with metallic lithium to generate an electron conductor which is stable under battery charging and discharging conditions, a first solid electrolyte layer, and a negative electrode active material layer that is in contact with the first solid electrolyte layer. The positive electrode active material layer, the metallic lithium absorption layer, the first solid electrolyte layer, and the negative electrode active material layer are disposed in this order. The first solid electrolyte layer of the all-solid lithium secondary battery contains a solid electrolyte. The solid electrolyte contained in the first solid electrolyte layer is a crystalline or amorphous sulfide solid electrolyte or a crystalline or amorphous oxide solid electrolyte.

The all-solid lithium secondary battery may further include a second solid electrolyte layer between the positive electrode active material layer and the metallic lithium absorption layer.

The metallic lithium reactive substance may have lithium ion conductivity.

The metallic lithium reactive substance may be a solid electrolyte containing Li, P, S, and M. M may be Ge, Si, Sn, or a combination thereof.

The metallic lithium reactive substance may be a Li_{3.25}Ge_{0.25}P_{0.75}S₄, Li₁₀GeP₂S₁₂, Li₁₀SnP₂S₁₂, Li₁₁Si₂PS₁₂, or Li₄GeS₄-Li₃PS₄ glass ceramic, a Li-Si-P-S-Cl solid electrolyte having an LGPS type structure, or a combination thereof.

The negative electrode active material layer may contain metallic lithium.

A second aspect of the present invention relates to a method of determining a deterioration state of an all-solid lithium secondary battery, including a first process of charging and discharging the all-solid lithium secondary battery; a second process of measuring a charging capacity and a discharging capacity of the all-solid lithium secondary battery during the charging and discharging; and a third process of determining a deterioration state of the all-solid lithium secondary battery from the relationship between the discharging capacity and the charging capacity.

In the third process, when the difference between the discharging capacity and the charging capacity is equal to or greater than a first threshold value or when a proportion of the charging capacity with respect to the discharging capacity is equal to or lower than a second threshold value, it may be determined that the all-solid lithium secondary battery has deteriorated.

According to the present disclosure, it is possible to provide an all-solid lithium secondary battery that can restrict internal short circuiting and detect whether the all-solid lithium secondary battery has deteriorated before internal short circuiting occurs, and a method of detecting whether an all-solid lithium secondary battery has deteriorated.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1A is a schematic view of an all-solid lithium secondary battery having no mechanism for restricting dendrite growth;
FIG. 1B is a schematic view showing a dendrite growth state when the all-solid lithium secondary battery shown in FIG. 1A is charged and discharged;
FIG. 1C is a schematic view showing a dendrite growth state when the all-solid lithium secondary battery shown in FIG. 1A is charged and discharged;
FIG. 2A is a schematic view of an all-solid lithium secondary battery having a shut layer;
FIG. 2B is a schematic view showing a dendrite growth state when the all-solid lithium secondary battery shown in FIG. 2A is charged and discharged;
FIG. 2C is a schematic view showing a dendrite growth state when the all-solid lithium secondary battery shown in FIG. 2A is charged and discharged;
FIG. 3A is a schematic view of an all-solid lithium secondary battery according to an embodiment of the present disclosure;
FIG. 3B is a schematic view showing a dendrite growth state when the all-solid lithium secondary battery shown in FIG. 3A is charged and discharged;
FIG. 3C is a schematic view showing a dendrite growth state when the all-solid lithium secondary battery shown in FIG. 3A is charged and discharged;
FIG. 3D is a schematic view of an all-solid lithium secondary battery according to a modification of the embodiment of the present disclosure;
FIG. 4 is a graph showing the charging and discharging capacities when an all-solid lithium secondary battery of Example 1 is charged and discharged;
FIG. 5 is a graph showing the charging and discharging capacities when an all-solid lithium secondary battery of Example 2 is charged and discharged;
FIG. 6 is a graph showing the charging and discharging capacities when an all-solid lithium secondary battery of Example 3 is charged and discharged;
FIG. 7 is a graph showing the charging and discharging capacities when an all-solid lithium secondary battery of Comparative Example 1 is charged and discharged;
FIG. 8 is a graph showing the charging and discharging capacities when an all-solid lithium secondary battery of Comparative Example 2 is charged and discharged;
FIG. 9 is a graph showing the charging and discharging capacities when an all-solid lithium secondary battery of Comparative Example 3 is charged and discharged; and
FIG. 10 is a graph showing the charging and discharging capacities when an all-solid lithium secondary battery of Comparative Example 4 is charged and discharged.

### DETAILED DESCRIPTION OF EMBODIMENTS

Embodiments of the present disclosure will be described below in detail. Here, the present disclosure is not limited to the following embodiments, and various modifications can be made within the scope of the gist of the disclosure.

### «All-solid lithium secondary battery»

An all-solid lithium secondary battery of the present disclosure has a positive electrode active material layer, a metallic lithium absorption layer, a solid electrolyte layer, and a negative electrode active material layer in this order. Here, the solid electrolyte layer is in contact with the negative electrode active material layer. In addition, the metallic lithium absorption layer contains a metallic lithium reactive substance. The metallic lithium reactive substance reacts with metallic lithium to generate a stable electron conductor under battery charging and discharging conditions.

The lithium secondary battery of the present disclosure can have, for example, a structure having a positive electrode current collector layer, a positive electrode active material layer, a metallic lithium absorption layer, a solid electrolyte layer, a negative electrode active material layer, and a negative electrode current collector layer in this order. In addition, the lithium secondary battery of the present disclosure may have a structure in which a solid electrolyte layer is additionally provided between a positive electrode active material layer and a metallic lithium absorption layer.

Although not limited by this principle, the principle under which the all-solid lithium secondary battery of the present disclosure can restrict internal short circuiting and it is possible to detect whether an all-solid lithium secondary battery has deteriorated before internal short circuiting occurs is as follows.

First, a dendrite growth state in an all-solid lithium secondary battery having no mechanism for restricting dendrite growth will be described.

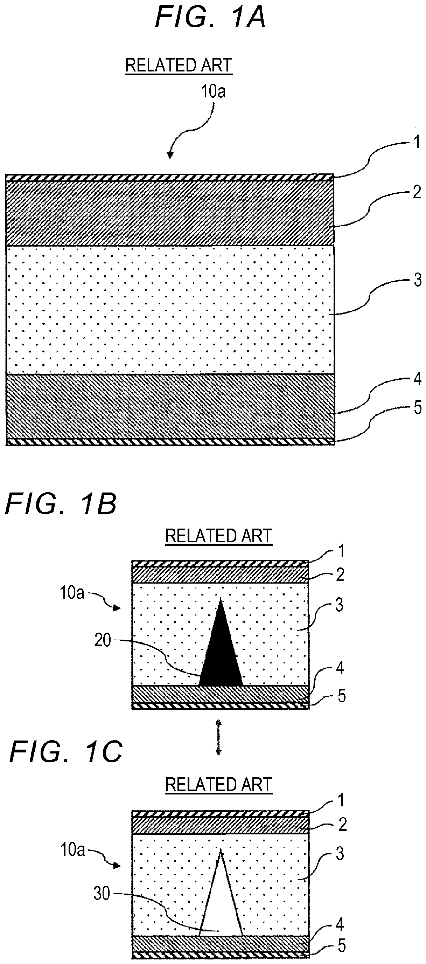

FIG. 1A is a schematic view of an all-solid lithium secondary battery 10a having no mechanism for restricting dendrite growth. In FIG. 1A, the all-solid lithium secondary battery 10a has a positive electrode current collector layer 1, a positive electrode active material layer 2, a solid electrolyte layer 3, a negative electrode active material layer 4, and a negative electrode current collector layer 5 in this order.

In addition, FIGS. 1B and 1C are schematic views showing growth states of a dendrite 20 when the all-solid lithium secondary battery 10a shown in FIG. 1A is charged and discharged. Here, FIG. 1B shows a state in which the all-solid lithium secondary battery 10a in which the dendrite 20 have grown to some extent is charged. In addition, FIG. 1C shows a state in which the all-solid lithium secondary battery 10a in the state in FIG. 1B is discharged.

As shown in FIG. 1B, in the all-solid lithium secondary battery 10a, metallic lithium dendrite 20 can grow from the side of the negative electrode active material layer 4 according to charging.

As shown in FIG. 1C, the grown dendrite 20 decomposes into lithium ions and disappears or shrinks during discharging, and a gap 30 remains in a part in which the dendrite 20 was formed. Therefore, there is no significant change in the charging and discharging capacities, and apparently, normal charging and discharging occur. Therefore, it is difficult to detect a growth state of the dendrite 20 until the dendrite 20 grows and reaches the positive electrode active material layer 2 and internal short circuiting occurs.

Next, a dendrite growth state in an all-solid lithium secondary battery having a shut layer, that is, a layer containing a substance that reacts with a dendrite to generate an electronic insulator will be described. Here, examples of a substance that reacts with a dendrite to generate an electronic insulator include tetrafluoroethylene (TFE) described in WO 2015/182615.

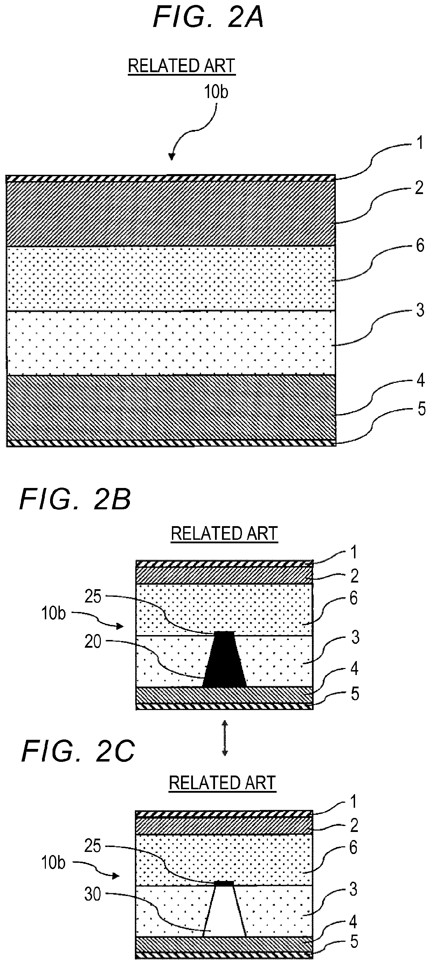

FIG. 2A is a schematic view of an all-solid lithium secondary battery 10b having a shut layer 6. In FIG. 2A, the all-solid lithium secondary battery 10b has the positive electrode current collector layer 1, the positive electrode active material layer 2, the shut layer 6, the solid electrolyte layer 3, the negative electrode active material layer 4, and the negative electrode current collector layer 5 in this order.

In addition, FIGS. 2B and 2C are schematic views showing growth states of the dendrite 20 when the all-solid lithium secondary battery 10b having the shut layer 6 is charged and discharged. Here, FIG. 2B shows a state in which the all-solid lithium secondary battery 10b in which the metallic lithium dendrite 20 has grown to the shut layer 6 is charged. In addition, FIG. 2C shows a state in which the all-solid lithium secondary battery 10b in the state in FIG. 2B is discharged.

As shown in FIG. 2B, when the all-solid lithium secondary battery 10b is repeatedly charged and discharged, the dendrite 20 gradually grows from the side of the negative electrode active material layer 4 and reaches the shut layer 6. The dendrite 20 that has reached the shut layer 6 reacts with a substance that reacts with a dendrite to generate an electronic insulator in the shut layer 6 to form an electronic insulator 25. Thereby, additional growth of the dendrite 20 toward the positive electrode active material layer 2 is restricted.

In addition, as shown in FIG. 2C, the grown dendrite 20 decomposes into lithium ions and disappears or shrinks during discharging, and the gap 30 remains in a part in which the dendrite 20 is formed. Since the electronic insulator 25 does not decompose into lithium ions during discharging, an irreversible capacity is generated in the all-solid lithium secondary battery 10b. However, the electronic insulator 25 is only formed at an interface between the solid electrolyte layer 3 and the shut layer 6 in the dendrite 20, and an amount thereof is very small. Therefore, there is no significant change in the charging and discharging capacities, and apparently, normal charging and discharging occur. Therefore, it is difficult to detect a growth state of the dendrite 20. In particular, when restriction of the growth of the dendrite 20 is not sufficient, it is difficult to detect a growth state of the dendrite 20 until the dendrite 20 grows and reaches a positive electrode active material layer, and internal short circuiting occurs.

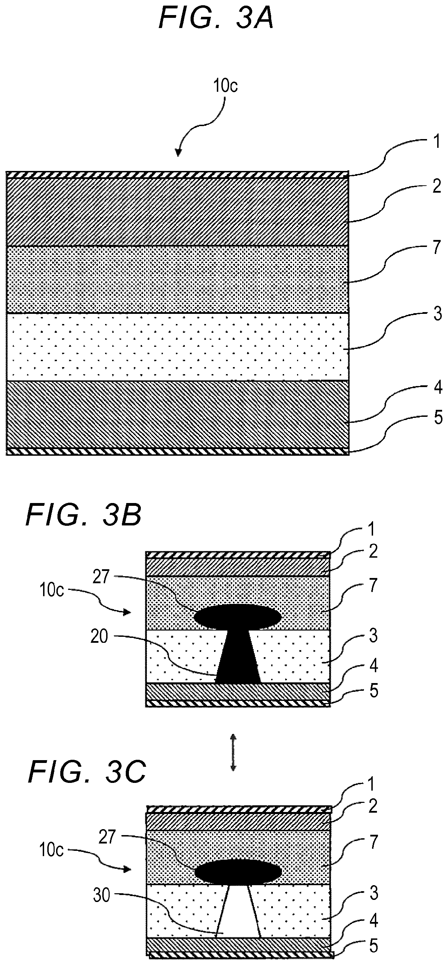

The all-solid lithium secondary battery of the present disclosure has a positive electrode active material layer, a metallic lithium absorption layer, a solid electrolyte layer, and a negative electrode active material layer in this order, and it is possible to detect deterioration of the lithium secondary battery due to the growth of metallic lithium dendrites before internal short circuiting occurs. Hereinafter, the principle will be described with reference to FIG. 3A and FIG. 3B, but the all-solid lithium secondary battery of the present disclosure is not limited to the configuration shown in FIG. 3A and FIG. 3B.

FIG. 3A is a schematic view of an all-solid lithium secondary battery 10c according to an embodiment of the present disclosure. In FIG. 3A, the all-solid lithium secondary battery 10c has the positive electrode current collector layer 1, the positive electrode active material layer 2, a metallic lithium absorption layer 7, the solid electrolyte layer 3, the negative electrode active material layer 4, and the negative electrode current collector layer 5 in this order.

In addition, FIG. 3B is a schematic view showing a dendrite growth state when the all-solid lithium secondary battery 10c shown in FIG. 3A is charged and discharged. Here, FIG. 3B shows a state in which the all-solid lithium secondary battery in which a dendrite has grown to a metallic lithium absorption layer is charged. In addition, FIG. 3C shows a state in which the all-solid lithium secondary battery in the state in FIG. 3B is discharged.

As shown in FIG. 3B, when the all-solid lithium secondary battery 10c is repeatedly charged and discharged, the dendrite 20 gradually grows from the side of the negative electrode active material layer 4 and reaches the metallic lithium absorption layer 7. The dendrite 20 that has reached the metallic lithium absorption layer 7 reacts with a metallic lithium reactive substance contained in the metallic lithium absorption layer 7 to generate a stable electron conductor 27 under battery charging and discharging conditions. Therefore, it is possible to restrict additional growth of the metallic lithium dendrite 20 toward the positive electrode active material layer.

The electron conductor 27 receives electrons from the dendrite 20 that extends from the negative electrode active material layer 4 during charging. Therefore, the reaction between metallic lithium and the metallic lithium reactive substance further proceeds at an interface between the electron conductor 27 and the metallic lithium reactive substance.

In addition, as shown in FIG. 3C, since the electron conductor 27 is stable under battery charging and discharging conditions, no lithium ions are generated when the battery is discharged, and an irreversible capacity is generated. Therefore, when the dendrite 20 grows and reaches the metallic lithium absorption layer 7, the discharging capacity of the all-solid lithium secondary battery is significantly lower than the charging capacity.

Therefore, in the all-solid lithium secondary battery of the present disclosure, when the charging and discharging capacities are measured, it is possible to detect the fact that the dendrite has grown and reached the metallic lithium absorption layer.

### <Metallic lithium absorption layer>

The metallic lithium absorption layer contains a metallic lithium reactive substance.

### (Metallic lithium reactive substance)

The metallic lithium reactive substance is a substance that reacts with metallic lithium to generate an electron conductor which is stable under battery charging and discharging conditions. When the metallic lithium reactive substance reacts with metallic lithium, it may generate, for example, a substance having no ion conductivity and/or electron conductivity in addition to the electron conductor.

The metallic lithium reactive substance is preferably a substance having lithium ion conductivity, for example, a solid electrolyte. Therefore, the metallic lithium reactive substance can be referred to as a solid electrolyte which has a significantly greater tendency to generate the above stable electron conductor than a solid electrolyte used in the solid electrolyte layer.

When the metallic lithium reactive substance contained in the metallic lithium absorption layer has lithium ion conductivity, it is possible to restrict an increase in internal resistance of the all-solid lithium secondary battery due to the disposition of the metallic lithium absorption layer.

Specifically, the metallic lithium reactive substance may be a solid electrolyte containing Li, P, S, and M as components. Here, M is Ge, Si, Sn, or a combination thereof.

Examples of such a composition include Li_{3.25}Ge_{0.25}P_{0.75}S₄, Li₁₀GeP₂S₁₂, Li₁₀SnP₂S₁₂, Li₁₁Si₂PS₁₂, and Li₄GeS₄-Li₃PS₄ glass ceramics, a Li-Si-P-S-Cl solid electrolyte having an LGPS (Li₁₀GeP₂S₁₂) type structure, and combinations thereof.

Here, for example, when the metallic lithium reactive substance is Li₁₀GeP₂S₁₂, the reaction between the metallic lithium reactive substance and metallic lithium is expressed by the following Formulae (a) to (c).

Li₁₀GeP₂S₁₂+4Li⁺+4e⁻→Ge+4Li₂S+2Li₃PS₄ (a)

Ge+yLi⁺+ye⁻→Li_{y}Ge (b)

Li₃PS₄+(5+x)Li⁺+(5+x)e⁻→LiₓP+4Li₂S (c)

Ge and Li₃PS₄ generated in Formula (a) each react with metallic lithium in Formulae (b) and (c). More specifically, in Formula (b), Ge reacts with metallic lithium to generate Li_{y}Ge, and in Formula (c), Li₃PS₄ reacts with metallic lithium to generate LiₓP and 4Li₂S.

Here, the products LiₓP and 4Li₂S in Formula (c) both have neither electron conductivity nor ion conductivity. However, the product Li_{y}Ge in Formula (b) is an electron conductor and is stable under battery charging and discharging conditions.

### <Solid electrolyte layer>

One solid electrolyte layer of the lithium secondary battery of the present disclosure is in contact with the negative electrode active material layer.

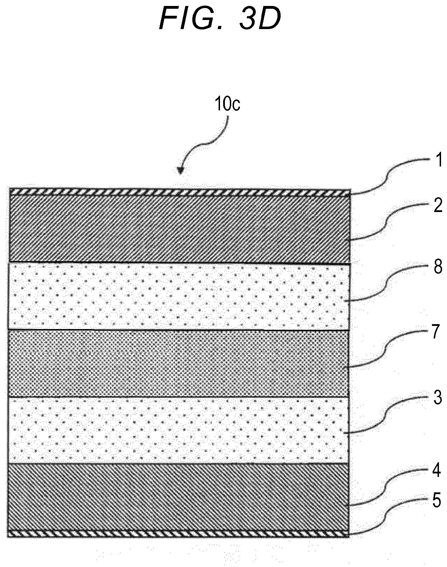

As shown in FIG. 3D, the lithium secondary battery of the present disclosure may have additionally another solid electrolyte layer 8 which contacts the positive electrode active material layer 2 and is provided between the positive electrode active material layer 2 and the metallic lithium absorption layer 7.

The solid electrolyte layer of the lithium secondary battery of the present disclosure contains a solid electrolyte and can contain an optional binder. Regarding the solid electrolyte, any material which has low reactivity with metallic lithium and can be used as a solid electrolyte of the all-solid battery can be used as long as the solid electrolyte is a crystalline or amorphous sulfide solid electrolyte or a crystalline or amorphous oxide solid electrolyte. In addition, the solid electrolyte may be a powder or a sintered product may be used.

Examples of sulfide solid electrolytes include a sulfide amorphous solid electrolyte, a sulfide crystalline solid electrolyte, and an argyrodite solid electrolyte, but the present disclosure is not limited thereto. Specific examples of sulfide solid electrolytes include Li₂S-P₂S₅ types (Li₇P₃S₁₁, Li₃PS₄, Li₈P₂S₉, and the like), Li₂S-SiS₂, LiI-Li₂S-SiS₂, LiI-Li₂S-P₂S₅, LiI-LiBr-Li₂S-P₂S₅, LiI-Li₂S-P₂O₅, LiI-Li₃PO₄-P₂S₅, Li₇₋ₓPS₆₋ₓClₓ and the like; and combinations thereof, but the present disclosure is not limited thereto.

Examples of oxide solid electrolytes include Li₇La₃Zr₂O₁₂, Li₇₋ₓLa₃Zr₁₋ₓNbₓO₁₂, Li₇₋₃ₓLa₃Zr₂AlₓO₁₂, Li₃ₓLa_{2/3-x}TiO₃, Li₁₊ₓAlₓTi₂₋ₓ(PO₄)₃, Li₁₊ₓAlₓGe₂₋ₓ(PO₄)₃, Li₃PO₄, and Li₃₊ₓPO₄₋ₓNₓ(LiPON), but the present disclosure is not limited thereto.

The solid electrolyte may be glass or crystallized glass (glass ceramic). In addition, the solid electrolyte layer may contain a binder and the like as necessary in addition to the above solid electrolytes. Specific examples are the same as "binders" listed in the following "positive electrode active material layer."

### <Positive electrode active material layer>

The positive electrode active material layer includes at least a positive electrode active material, and preferably further includes a solid electrolyte mentioned in the above solid electrolyte layer. In addition, according to intended uses, intended purposes, and the like, for example, additives used for the positive electrode active material layer of the all-solid battery such as a conductive aid and a binder can be included.

The material of the positive electrode active material is not particularly limited. For example, the positive electrode active material may be lithium cobalt oxide (LiCoO₂), lithium nickelate (LiNiO₂), lithium manganite (LiMn₂O₄), LiCo_{1/3}Ni_{1/3}Mn_{1/3}O₂, a heteroelement-substituted Li-Mn spinel having a composition represented by Li₁₊ₓMn_{2-x-y}M_{y}O₄ (M is at least one metal element selected from among Al, Mg, Co, Fe, Ni, and Zn), or the like, but the present disclosure is not limited thereto.

The conductive aid is not particularly limited. For example, the conductive aid may be a carbon material such as a vapor grown carbon fiber (VGCF) and a carbon nanofiber, a metal material, or the like, but the present disclosure is not limited thereto.

The binder is not particularly limited. For example, the binder may be a material such as polyvinylidene fluoride (PVdF), carboxymethyl cellulose (CMC), butadiene rubber (BR) or styrene butadiene rubber (SBR), or a combination thereof, but the present disclosure is not limited thereto.

### «Negative electrode active material layer»

The negative electrode active material layer includes at least a negative electrode active material, and preferably further includes the above solid electrolytes. In addition, according to intended uses, intended purposes, and the like, for example, additives used for the negative electrode active material layer of the lithium ion secondary battery such as the above conductive aid and binder can be included.

### (Negative electrode active material)

The material of the negative electrode active material is not particularly limited, and may be metallic lithium and may be a material that can occlude and release metal ions such as lithium ions. Regarding the material that can occlude and release metal ions such as lithium ions, for example, the negative electrode active material may be an alloy-based negative electrode active material, a carbon material, or the like, but the present disclosure is not limited thereto.

The alloy-based negative electrode active material is not particularly limited, and examples thereof include a Si alloy-based negative electrode active material and a Sn alloy-based negative electrode active material. Examples of Si alloy-based negative electrode active materials include silicon, silicon oxide, silicon carbide, silicon nitride, and solid solutions thereof. In addition, the Si alloy-based negative electrode active material can contain elements other than silicon, for example, Fe, Co, Sb, Bi, Pb, Ni, Cu, Zn, Ge, In, Sn, and Ti. Examples of Sn alloy-based negative electrode active materials include tin, tin oxide, tin nitride, and solid solutions thereof. In addition, the Sn alloy-based negative electrode active material can contain elements other than tin, for example, Fe, Co, Sb, Bi, Pb, Ni, Cu, Zn, Ge, In, Ti, and Si. Among these, the Si alloy-based negative electrode active material is preferable.

The carbon material is not particularly limited, and examples thereof include hard carbon, soft carbon, and graphite.

### <Current collector layer>

The lithium secondary battery of the present disclosure can have, for example, a structure having a positive electrode current collector layer, a positive electrode active material layer, a metallic lithium absorption layer, a solid electrolyte layer, a negative electrode active material layer, and a negative electrode current collector layer in this order.

### (Positive electrode current collector layer)

The material used for the positive electrode current collector layer is not particularly limited, and those that can be used for the all-solid battery may be appropriately used. For example, the material used for the positive electrode current collector layer may be SUS, aluminum, copper, nickel, iron, titanium, carbon, or the like, but the present disclosure is not limited thereto.

The shape of the positive electrode current collector layer is not particularly limited, and examples thereof include a foil shape, a plate shape, and a mesh shape. Among these, a foil shape is preferable.

### (Negative electrode current collector layer)

The material used for the negative electrode current collector layer is not particularly limited, and those that can be used for the all-solid battery may be appropriately used. For example, the material used for the negative electrode current collector layer may be SUS, aluminum, copper, nickel, iron, titanium, carbon, or the like, but the present disclosure is not limited thereto.

The shape of the negative electrode current collector layer is not particularly limited, and examples thereof include a foil shape, a plate shape, and a mesh shape. Among these, a foil shape is preferable.

### «Deterioration determination method»

A deterioration determination method of the present disclosure includes the following processes (A) to (C):
(A) charging and discharging an all-solid lithium secondary battery of the present disclosure,
(B) measuring a charging capacity and a discharging capacity of the all-solid lithium secondary battery during charging and discharging, and
(C) determining a deterioration state of the all-solid lithium secondary battery from the relationship between the discharging capacity and the charging capacity.

In the determination method of the present disclosure, the deterioration of the all-solid lithium secondary battery is deterioration that is caused by growth of metallic lithium dendrites, and for example, metallic lithium dendrites grow and reach the metallic lithium absorption layer, and an irreversible capacity is generated, and thereby the discharging capacity is reduced.

In the determination method of the present disclosure, the all-solid battery that has been determined to have deteriorated may be used directly or it may be replaced immediately or after it is additionally used for a certain time or use conditions such as a charging and discharging rate may be changed.

As shown in FIG. 3B, when the all-solid lithium secondary battery 10c of the present disclosure is repeatedly charged and discharged, the dendrite 20 gradually grows from the side of the negative electrode active material layer 4 and reaches the metallic lithium absorption layer 7. The dendrite 20 that has reached the metallic lithium absorption layer 7 reacts with the metallic lithium reactive substance contained in the metallic lithium absorption layer 7 to generate the electron conductor 27 which is stable under battery charging and discharging conditions.

Since the electron conductor 27 generated due to the reaction is stable under battery charging and discharging conditions, no lithium ions are generated when the battery is discharged, and an irreversible capacity is generated. Then, when a dendrite grows and reaches the metallic lithium absorption layer, the discharging capacity of the all-solid lithium secondary battery is significantly lower than the charging capacity.

Therefore, in the all-solid lithium secondary battery of the present disclosure, when the charging and discharging capacities are measured, it is possible to detect the fact that metallic lithium dendrites have grown and reached the metallic lithium absorption layer.

### <Process (A)>

In the process (A), the all-solid lithium secondary battery of the present disclosure is charged and discharged. Charging and discharging conditions are not particularly limited.

The charging and discharging conditions may be, for example, charging and discharging conditions when the battery is used.

### <Process (B)>

In the process (B), a charging capacity and a discharging capacity of the all-solid lithium secondary battery of the present disclosure are measured during charging and discharging.

Regarding the method of measuring a charging capacity and a discharging capacity, any method of measuring a charging capacity and a discharging capacity of a battery can be performed, and for example, charging and discharging current amounts can be summed.

### <Process (C)>

In the process (C), the deterioration state of the all-solid lithium secondary battery is determined from the relationship between the discharging capacity and the charging capacity measured in the process (B).

The determination in the process (C) can be performed using any method in which it is determined that the all-solid lithium secondary battery has deteriorated when a metallic lithium dendrite has grown and reached the metallic lithium absorption layer, and it is determined that the all-solid lithium secondary battery has not deteriorated when a metallic lithium dendrite has not grown and reached the metallic lithium absorption layer. Therefore, in the determination in the process (C), it is not always necessary to determine whether a metallic lithium dendrite has grown and reached the metallic lithium absorption layer.

It is preferable that the relationship between the discharging capacity and the charging capacity before a dendrite reaches the metallic lithium absorption layer and the relationship between the discharging capacity and the charging capacity when a dendrite grows and reaches the metallic lithium absorption layer can be identified each other in the determination in the process (C).

In the determination in the process (C), specifically, when the difference between the discharging capacity and the charging capacity is equal to or larger than a threshold value, it may be determined that the all-solid lithium secondary battery has deteriorated. In addition, in another determination method, when a proportion of the charging capacity with respect to the discharging capacity is equal to or lower than a threshold value, it may be determined that the all-solid lithium secondary battery has deteriorated.

The threshold value can be determined as any value that can identify the relationship between the discharging capacity and the charging capacity before and after a dendrite reaches the metallic lithium absorption layer.

The threshold value may be determined so that, for example, when the sample of the all-solid lithium secondary battery of the present disclosure is charged and discharged, respective discharging capacities and charging capacities before a dendrite reaches the metallic lithium absorption layer and after a dendrite reaches the metallic lithium absorption layer are measured, the relationship between the discharging capacity and the charging capacity before a dendrite reaches the metallic lithium absorption layer and the relationship between the discharging capacity and the charging capacity when a dendrite reaches the metallic lithium absorption layer can be distinguished.

### <<Example 1>>

Here, 50 mg of a halogen-containing Li-P-S solid electrolyte was weighed out and put into a ceramic die with an inner diameter of 11.28 mm (1 cm²), and uniaxial molding was performed using a steel pin at a load of 10 kN for 1 minute, and thereby a first layer made of the halogen-containing Li-P-S solid electrolyte was molded. Here, the first layer was a solid electrolyte layer.

Next, 50 mg of a Li₁₀GeP₂S₁₂ solid electrolyte as a metallic lithium reactive substance was weighed out and put into the ceramic die from one side of the first layer, and uniaxial molding was performed using a steel pin at a load of 5 kN for 1 minute, and thereby a second layer made of the Li₁₀GeP₂S₁₂ solid electrolyte was molded. Here, the second layer is a metallic lithium absorption layer.

Next, 50 mg of a halogen-containing Li-P-S solid electrolyte was weighed out and put into a ceramic die from the side of the second layer, and uniaxial molding was performed using a steel pin at a load of 5 kN for 1 minute, and thereby a third layer made of the halogen-containing Li-P-S solid electrolyte was molded. Here, the third layer was a solid electrolyte layer.

Next, 40 mg of LiNi_{1/3}Co_{1/3}Mn_{1/3}O₂ as a positive electrode active material was weighed out and put into a ceramic die from the side of the third layer, a copper foil with a thickness of 10 µm as a negative electrode current collector layer was put into a ceramic die from the side of the first layer, uniaxial molding was performed at a load of 60 kN for 3 minutes, a positive electrode active material layer was molded on the side of the third layer, a negative electrode current collector layer was disposed on the side of the first layer, and thereby a cell was completed.

Finally, the cell was restrained at a load of 250 kgf, and thereby an all-solid lithium secondary battery of Example 1 was prepared.

The prepared all-solid lithium secondary battery of Example 1 had the first layer (solid electrolyte layer), the second layer (metallic lithium absorption layer), and the third layer (solid electrolyte layer) between the negative electrode current collector layer and the positive electrode active material layer in this order from the side of the negative electrode current collector layer.

### <<Example 2>>

An all-solid lithium secondary battery of Example 2 was prepared in the same manner as in Example 1 except that a Li-Si-P-S-Cl solid electrolyte was used in place of the Li₁₀GeP₂S₁₂ solid electrolyte as the metallic lithium reactive substance. Here, the Li-Si-P-S-Cl solid electrolyte had an LGPS type structure. The Li-Si-P-S-Cl solid electrolyte used in the following Example 3 and Comparative Examples 3 and 4 also had the same structure.

The prepared all-solid lithium secondary battery of Example 2 had the first layer (solid electrolyte layer), the second layer (metallic lithium absorption layer), and the third layer (solid electrolyte layer) between the negative electrode current collector layer and the positive electrode active material layer from the side of the negative electrode current collector layer in this order.

### <<Example 3>>

Here, 50 mg of a halogen-containing Li-P-S solid electrolyte was weighed out and put into a ceramic die with an inner diameter of 11.28 mm (1 cm²), uniaxial molding was performed using a steel pin at a load of 10 kN for 1 minute, and thereby a first layer made of the halogen-containing Li-P-S solid electrolyte was molded. Here, the first layer was a solid electrolyte layer.

Next, 50 mg of a Li-Si-P-S-Cl solid electrolyte as the metallic lithium reactive substance was weighed out and put into a ceramic die from one side of the first layer, uniaxial molding was performed using a steel pin at a load of 5 kN for 1 minute, and thereby a second layer made of the Li-Si-P-S-Cl solid electrolyte was molded. Here, the second layer was a metallic lithium absorption layer.

Next, 40 mg of LiNi_{1/3}Co_{1/3}Mn_{1/3}O₂ as a positive electrode active material was weighed out and put into a ceramic die from the side of the second layer, a copper foil with a thickness of 10 µm was put into a ceramic die from the side of the first layer, uniaxial molding was performed at a load of 60 kN for 3 minutes, a positive electrode active material layer was molded on the side of the second layer, a negative electrode current collector layer was disposed on the side of the first layer, and thereby a cell was completed.

Finally, the cell was restrained at a load of 250 kgf, and thereby an all-solid lithium secondary battery of Example 3 was prepared.

The prepared all-solid lithium secondary battery of Example 3 had the first layer (solid electrolyte layer) and the second layer (metallic lithium absorption layer) between the negative electrode current collector layer and the positive electrode active material layer from the side of the negative electrode current collector layer in this order.

When the all-solid lithium secondary battery is being charged in the charging and discharging test 1 described below for the all-solid lithium secondary battery of Examples 1 to 3, a metal lithium is deposited on a surface of the negative electrode current collector, which is in contact with the first layer, whereby a negative electrode active material layer (Li layer) is self-formed.

### <<Comparative Example 1>>

Here, 150 mg of a halogen-containing Li-P-S solid electrolyte was weighed out and put into a ceramic die with an inner diameter of 11.28 mm (1 cm²), uniaxial molding was performed using a steel pin at a load of 10 kN for 1 minute, and thereby a first layer made of the halogen-containing Li-P-S solid electrolyte was molded. Here, the first layer was a solid electrolyte layer.

Next, 40 mg of LiNi_{1/3}Co_{1/3}Mn_{1/3}O₂ as a positive electrode active material was weighed out and put into a ceramic die from one side of the first layer, a copper foil with a thickness of 10 µm was put into a ceramic die from the other side of the first layer, uniaxial molding was performed at a load of 60 kN for 3 minutes, a positive electrode active material layer was molded on one side of the first layer, a negative electrode current collector layer was disposed on the other side, and thereby a cell was molded.

Finally, the cell was restrained at a load of 250 kgf, and thereby an all-solid lithium secondary battery of Comparative Example 1 was prepared.

The prepared all-solid lithium secondary battery of Comparative Example 1 had only the first layer (solid electrolyte layer) between the negative electrode current collector layer and the positive electrode active material layer.

### «Comparative Example 2»

An all-solid lithium secondary battery of Comparative Example 2 was prepared in the same manner as in Example 1 except that a Li₇P₃S₁₁ solid electrolyte as a solid electrolyte was used in place of the Li₁₀GeP₂S₁₂ solid electrolyte as the metallic lithium reactive substance. Here, the Li₇P₃S₁₁ solid electrolyte was a solid electrolyte having significantly low reactivity with metallic lithium.

The prepared all-solid lithium secondary battery of Comparative Example 2 had the first layer (solid electrolyte layer), the second layer (layer made of a Li₇P₃S₁₁ solid electrolyte), and the third layer (solid electrolyte layer) between the negative electrode current collector layer and the positive electrode active material layer from the side of the negative electrode current collector layer in this order.

### <<Comparative Example 3>>

An all-solid lithium secondary battery of Comparative Example 3 was prepared in the same manner as in Comparative Example 1 except that a Li-Si-P-S-Cl solid electrolyte as a metallic lithium reactive substance was used in place of the halogen-containing Li-P-S solid electrolyte having significantly low reactivity with metallic lithium.

The prepared all-solid lithium secondary battery of Comparative Example 3 had only the first layer (metallic lithium absorption layer) between the negative electrode current collector layer and the positive electrode active material layer.

### <<Comparative Example 4>>

An all-solid lithium secondary battery of Comparative Example 4 was prepared in the same manner as in Example 3 except that a lamination order of the solid electrolyte layer and the metallic lithium absorption layer was changed.

Here, the prepared all-solid lithium secondary battery of Comparative Example 4 had the first layer (metallic lithium absorption layer) and the second layer (solid electrolyte layer) between the negative electrode current collector layer and the positive electrode active material layer from the side of the negative electrode current collector layer in this order.

### <<Measurement of charging and discharging capacities>>

### <Charging and discharging test 1>

The all-solid lithium secondary batteries of Examples 1 to 3 and Comparative Examples 1 to 4 were charged and discharged under conditions of a lower limit voltage of 3.0 V, an upper limit voltage of 4.37 V, a charging and discharging rate of 0.1 C, and a current density of 456 µA/cm², that is, under conditions of a low current density, and thereby it was checked whether these batteries operated.

The all-solid lithium secondary batteries of Examples 1 to 3, and Comparative Examples 1 and 2 operated as batteries, but Comparative Examples 3 and 4 did not operate as batteries.

### <Charging and discharging test 2>

The all-solid lithium secondary batteries of Examples 1 to 3 and Comparative Examples 1 and 2 of which functions as the battery were confirmed were charged and discharged under conditions of a lower limit voltage of 3.0 V, an upper limit voltage of 4.37 V, a charging and discharging rate of 2.0 C, and a current density of 9.12 mA/cm², that is, conditions of a high current density, and thereby the charging capacity and the discharging capacity of the all-solid lithium secondary batteries were measured.

### <Results and conclusions>

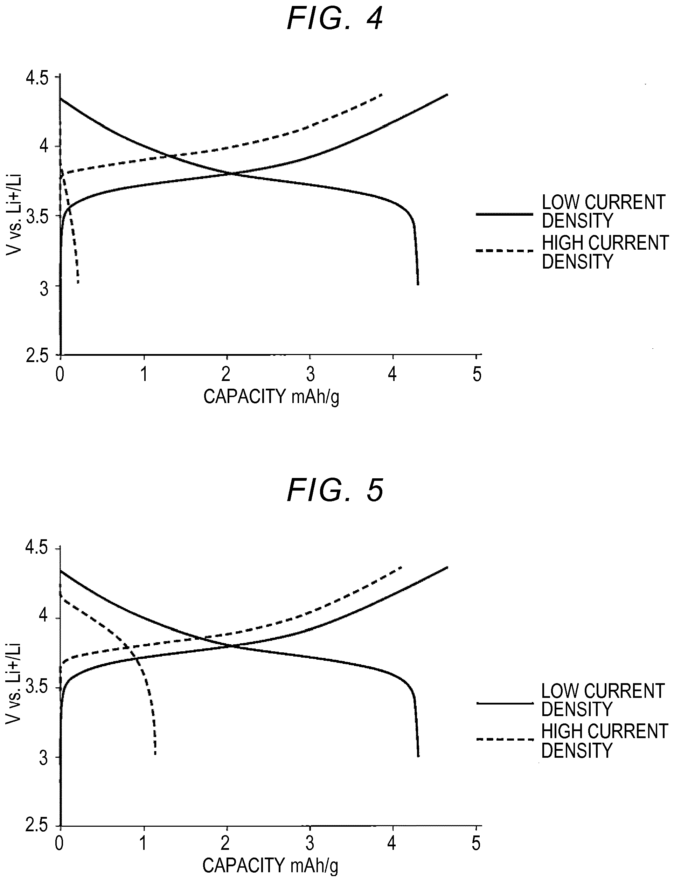

Table 1 shows the configurations of the all-solid lithium secondary batteries and results of the above two charging and discharging tests. In addition, FIGS. 4 to 10 show graphs showing charging and discharging capacities of the all-solid lithium secondary batteries when the charging and discharging tests 1 and 2 were performed. Here, in FIGS. 4 to 10, solid line and dotted line graphs show measurement results of charging and discharging capacities of the all-solid lithium secondary batteries when charging and discharging were performed according to the charging and discharging tests 1 and 2.

**Table 1**

| Examples | Configurations of layers between negative electrode current collector layer and positive electrode active material layer | | | Measurement results | |
|---|---|---|---|---|---|
| | First layer | Second layer | Third layer | Charging and discharging test 1 (low current density) | Charging and discharging test 2 (high current density) |
| Example 1 | Solid electrolyte layer | Metallic lithium absorption layer | Solid electrolyte layer | Operated | No short circuiting Low discharging capacity |
| Example 2 | Solid electrolyte layer | Metallic lithium absorption layer | Solid electrolyte layer | Operated | No short circuiting Low discharging capacity |
| Example 3 | Solid electrolyte layer | Metallic lithium absorption layer | - | Operated | No short circuiting Low discharging capacity |
| Comparative Example 1 | Solid electrolyte layer | - | - | Operated | Short circuiting occurred |
| Comparative Example 2 | Solid electrolyte layer | Solid electrolyte layer | Solid electrolyte layer | Operated | Short circuiting occurred |
| Comparative Example 3 | Metallic lithium absorption layer | - | - | Not operated | - |
| Comparative Example 4 | Metallic lithium absorption layer | Solid electrolyte layer | - | Not operated | - |

### (Charging and discharging test 1: charging and discharging test at a low current density)

As shown in the solid line graphs in FIGS. 4 to 8 and Table 1, in the all-solid lithium secondary batteries of Examples 1 to 3 and Comparative Examples 1 and 2, the operation as the battery was confirmed during charging and discharging at a low current density.

Comparing the all-solid lithium secondary batteries of Examples 1 and 2 and Comparative Examples 1 and 2, and the all-solid lithium secondary battery of Example 3, the all-solid lithium secondary batteries of Examples 1 and 2 and Comparative Examples 1 and 2 had a discharging capacity of 4 mAh/g or more, the all-solid lithium secondary battery of Example 3 had a discharging capacity of about 3 mAh/g, and the all-solid lithium secondary battery of Example 3 had a lower discharging capacity than the all-solid lithium secondary batteries of Examples 1 and 2 and Comparative Examples 1 and 2.

However, in all of the all-solid lithium secondary batteries of Examples 1 to 3, and Comparative Examples 1 and 2, the operation as the battery was not confirmed.

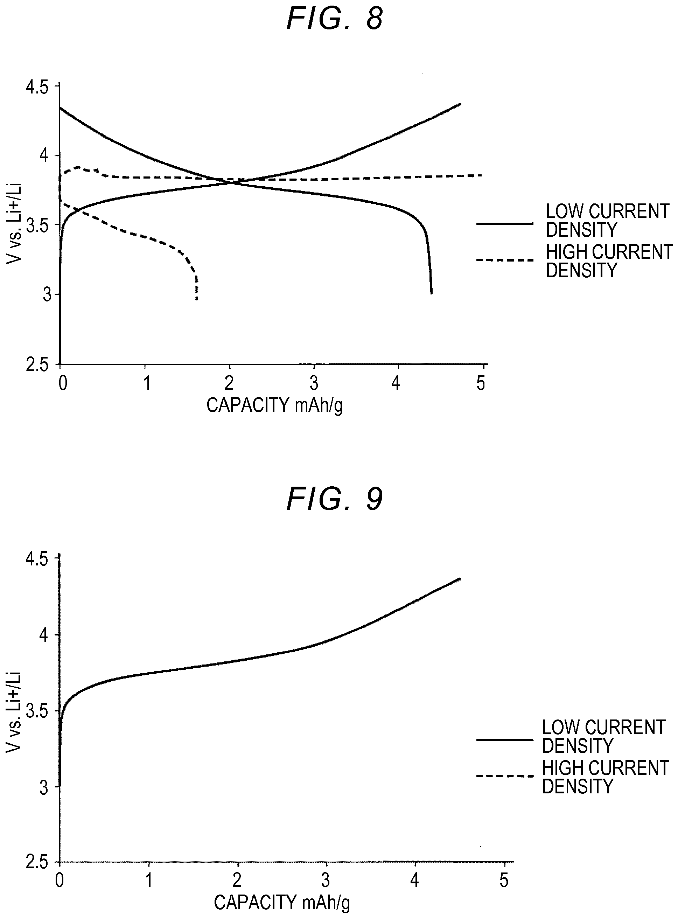

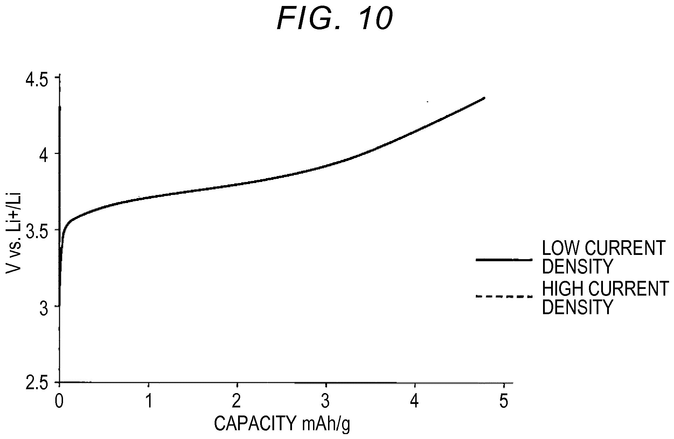

On the other hand, as shown in Table 1 and FIGS. 9 and 10, in the all-solid lithium secondary batteries of Comparative Examples 3 and 4, no discharging occurred, and the operation as the battery was not confirmed.

The reason why the all-solid lithium secondary batteries of Comparative Examples 3 and 4 did not operate is speculated to be as follows. The Li-Si-P-S-Cl solid electrolyte as the metallic lithium reactive substance contained in the first layer in contact with the negative electrode current collector layer reacted with metallic lithium precipitated on the negative electrode current collector layer during charging to generate a stable electron conductor. Therefore, lithium ions could not move from the side of the negative electrode current collector layer to the side of the positive electrode active material layer during discharging.

### (Charging and discharging test 2: charging and discharging test at a high current density)

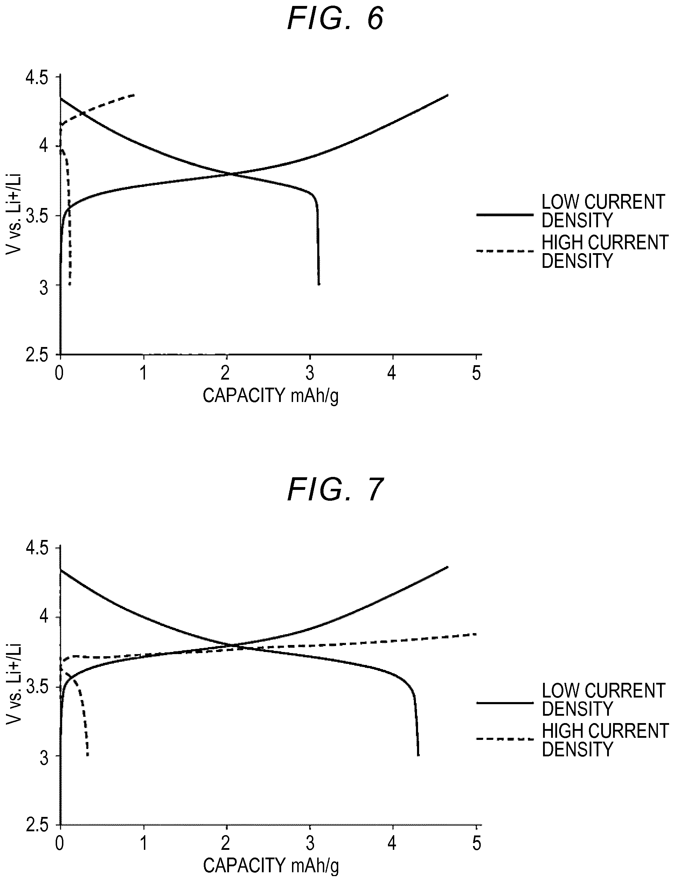

As shown in the dotted line graphs in FIGS. 7 to 8 and Table 1, in the all-solid lithium secondary batteries of Comparative Examples 1 and 2, the voltage did not increase during charging. This indicates that internal short circuiting occurred in the all-solid lithium secondary batteries of Comparative Examples 1 and 2 due to charging and discharging at a high current density.

On the other hand, as shown in the dotted line graphs in FIGS. 4 to 6 and Table 1, in the all-solid lithium secondary batteries of Examples 1 to 3, the voltage increased to the upper limit voltage during charging.

The results show that no internal short circuiting occurred in the all-solid lithium secondary batteries of Examples 1 to 3 when charging and discharging were performed at a high current density.

In addition, as shown in the dotted lines in FIGS. 4 to 6 and Table 1, in the all-solid lithium secondary batteries of Examples 1 to 3, the discharging capacity with respect to the charging capacity was significantly low during charging and discharging at a high current density. When the all-solid lithium secondary batteries of Examples 1 to 3 were disassembled after charging and discharging were performed at a high current density and respective layers were observed, the metallic lithium absorption layer was discolored black.

Based on the results, it was thought that, after the metallic lithium dendrite reached the metallic lithium absorption layer, metallic lithium reacted with the Li₁₀GeP₂S₁₂ solid electrolyte and the Li-Si-P-S-Cl solid electrolyte in the metallic lithium absorption layer to generate a stable electron conductor, and thereby an irreversible capacity was generated in these all-solid lithium secondary batteries.

## Claims

1. An all-solid lithium secondary battery, comprising:
a positive electrode active material layer (2);
a metallic lithium absorption layer (7) containing a metallic lithium reactive substance;
a first solid electrolyte layer (3); and
a negative electrode active material layer (4) that is in contact with the first solid electrolyte layer (3),
wherein the positive electrode active material layer (2), the metallic lithium absorption layer (7), the first solid electrolyte layer (3), and the negative electrode active material layer (4) are disposed in this order; and
wherein the first solid electrolyte layer (3) of the all-solid lithium secondary battery contains a solid electrolyte; **characterized in that**
the metallic lithium reactive substance contained in the metallic lithium absorption layer (7) reacts with metallic lithium to generate an electron conductor which is stable under charging and discharging conditions of the all-solid lithium secondary battery; and
the solid electrolyte contained in the first solid electrolyte layer (3) is a crystalline or amorphous sulfide solid electrolyte or a crystalline or amorphous oxide solid electrolyte.

2. The all-solid lithium secondary battery according to claim 1, further comprising a second solid electrolyte layer between the positive electrode active material layer (2) and the metallic lithium absorption layer (7).

3. The all-solid lithium secondary battery according to claim 1 or 2,
wherein the metallic lithium reactive substance has lithium ion conductivity.

4. The all-solid lithium secondary battery according to any one of claims 1 to 3,
wherein the metallic lithium reactive substance is a solid electrolyte containing Li, P, S, and M, and
wherein M is Ge, Si, Sn, or a combination thereof.

5. The all-solid lithium secondary battery according to claim 4,
wherein the metallic lithium reactive substance is a Li_{3.25}Ge_{0.25}P_{0.75}S₄, Li₁₀GeP₂S₁₂, Li₁₀SnP₂S₁₂, Li₁₁Si₂PS₁₂, or Li₄GeS₄-Li₃PS₄ glass ceramic, a Li-Si-P-S-Cl solid electrolyte having an LGPS type structure, or a combination thereof.

6. The all-solid lithium secondary battery according to any one of claims 1 to 5,
wherein the negative electrode active material layer (4) contains the metallic lithium.

7. A method of determining a deterioration state of an all-solid lithium secondary battery, comprising:
a first process of charging and discharging the all-solid lithium secondary battery (10c) according to any one of claims 1 to 6;
a second process of measuring a charging capacity and a discharging capacity of the all-solid lithium secondary battery (10c) during the charging and discharging; and
a third process of determining the deterioration state of the all-solid lithium secondary battery (10c) from a relationship between the discharging capacity and the charging capacity.

8. The method according to claim 7,
wherein, in the third process, when a difference between the discharging capacity and the charging capacity is equal to or greater than a first threshold value or when a proportion of the charging capacity with respect to the discharging capacity is equal to or lower than a second threshold value, it is determined that the all-solid lithium secondary battery (10c) has deteriorated.

## Patentansprüche

1. Festkörperlithiumsekundärbatterie mit
einer Positivelektrodenaktivmaterialschicht (2),
einer metallischen Lithiumabsorptionsschicht (7), die eine metallische Lithium-Reaktivsubstanz enthält,
einer ersten Festelektrolytschicht (3), und
einer Negativelektrodenaktivmaterialschicht (4), die in Kontakt mit der ersten Festelektrolytschicht (3) steht,
wobei die Positivelektrodenaktivmaterialschicht (2), die metallische Lithiumabsorptionsschicht (7), die erste Festelektrolytschicht (3) und die Negativelektrodenaktivmaterialschicht (4) in dieser Reihenfolge angeordnet sind, und
wobei die erste Festelektrolytschicht (3) der Festkörperlithiumsekundärbatterie einen Festelektrolyten enthält, **dadurch gekennzeichnet, dass**
die in der metallischen Lithiumabsorptionsschicht (7) enthaltene metallische Lithium-Reaktivsubstanz mit metallischem Lithium reagiert, um einen Elektronenleiter zu erzeugen, der unter den Lade- und Entladebedingungen der Festkörperlithiumsekundärbatterie stabil ist, und
der in der ersten Festelektrolytschicht (3) enthaltene Festelektrolyt ein kristalliner oder amorpher Sulfid-Festelektrolyt oder ein kristalliner oder amorpher Oxid-Festelektrolyt ist.

2. Festkörperlithiumsekundärbatterie nach Anspruch 1, die ferner eine zweite Festelektrolytschicht zwischen der Positivelektrodenaktivmaterialschicht (2) und der metallischen Lithiumabsorptionsschicht (7) umfasst.

3. Festkörperlithiumsekundärbatterie nach Anspruch 1 oder 2,
wobei die metallische Lithium-Reaktivsubstanz Lithium-Ionen-Leitfähigkeit aufweist.

4. Festkörperlithiumsekundärbatterie nach einem der Ansprüche 1 bis 3,
wobei die metallische Lithium-Reaktivsubstanz ein Festelektrolyt ist, der Li, P, S und M enthält, und
wobei M Ge, Si, Sn oder eine Kombination davon ist.

5. Festkörperlithiumsekundärbatterie nach Anspruch 4,
wobei die metallische Lithium-Reaktivsubstanz eine Li_{3.25}Ge_{0.25}P_{0.75}S₄, Li₁₀GeP₂S₁₂, Li₁₀SnP₂S₁₂, Li₁₁S₁₂PS₁₂, oder Li₄GeS₄-Li₃PS₄ Glaskeramik, ein Li-Si-P-S-Cl Festelektrolyt mit einer LGPS-Struktur oder eine Kombination davon ist.

6. Festkörperlithiumsekundärbatterie nach einem der Ansprüche 1 bis 5,
wobei die Negativelektrodenaktivmaterialschicht (4) das metallische Lithium enthält.

7. Verfahren zum Bestimmen eines Verschlechterungszustands einer Festkörperlithiumsekundärbatterie, wobei das Verfahren umfasst:
einen ersten Prozess, bei dem die Festkörperlithiumsekundärbatterie (10c) gemäß einem der Ansprüche 1 bis 6 geladen und entladen wird,
einen zweiten Prozess, bei dem eine Ladekapazität und eine Entladekapazität der Festkörperlithiumsekundärbatterie (10c) während des Ladens und Entladens gemessen wird, und
einen dritten Prozess, bei dem der Verschlechterungszustand der Festkörperlithiumsekundärbatterie (10c) aus einer Beziehung zwischen der Entladekapazität und der Ladekapazität bestimmt wird.

8. Verfahren nach Anspruch 7,
wobei in dem dritten Prozess, wenn eine Differenz zwischen der Entladekapazität und der Ladekapazität gleich oder größer als ein erster Schwellenwert ist oder wenn ein Anteil der Ladekapazität in Bezug auf die Entladekapazität gleich oder kleiner als ein zweiter Schwellenwert ist, bestimmt wird, dass sich die Festkörperlithiumsekundärbatterie (10c) verschlechtert hat.

## Revendications

1. Batterie rechargeable au lithium tout solide, comprenant :
une couche de matériau actif d'électrode positive (2) ;
une couche d'absorption de lithium métallique (7) contenant une substance réactive au lithium métallique ;
une première couche d'électrolyte solide (3) ; et
une couche de matériau actif d'électrode négative (4) qui est en contact avec la première couche d'électrolyte solide (3),
dans laquelle la couche de matériau actif d'électrode positive (2), la couche d'absorption de lithium métallique (7), la première couche d'électrolyte solide (3) et la couche de matériau actif d'électrode négative (4) sont disposées dans cet ordre ; et
dans laquelle la première couche d'électrolyte solide (3) de la batterie rechargeable au lithium tout solide contient un électrolyte solide ; **caractérisée en ce que**
la substance réactive au lithium métallique contenue dans la couche d'absorption de lithium métallique (7) réagit avec du lithium métallique pour générer un conducteur d'électrons qui est stable dans des conditions de charge et de décharge de la batterie rechargeable au lithium tout solide ; et
l'électrolyte solide contenu dans la première couche d'électrolyte solide (3) est un électrolyte solide au sulfure cristallin ou amorphe ou un électrolyte solide à oxyde cristallin ou amorphe.

2. Batterie rechargeable au lithium tout solide selon la revendication 1, comprenant en outre une seconde couche d'électrolyte solide entre la couche de matériau actif d'électrode positive (2) et la couche d'absorption de lithium métallique (7).

3. Batterie rechargeable au lithium tout solide selon la revendication 1 ou 2,
dans laquelle la substance réactive au lithium métallique présente une conductivité des ions lithium.

4. Batterie rechargeable au lithium tout solide selon l'une quelconque des revendications 1 à 3,
dans laquelle la substance réactive au lithium métallique est un électrolyte solide contenant Li, P, S et M et
dans laquelle M est Ge, Si, Sn ou une combinaison de ceux-ci.

5. Batterie rechargeable au lithium tout solide selon la revendication 4,
dans laquelle la substance réactive au lithium métallique est une vitrocéramique en Li_{3,25}Ge_{0,25}P_{0,75}S₄, Li₁₀GeP₂S₁₂, Li₁₀SnP₂S₁₂, Li₁₁Si₂PS₁₂, ou Li₄GeS₄-Li₃PS₄, un électrolyte solide au Li-Si-P-S-Cl présentant une structure du type LGPS, ou une combinaison de ceux-ci.

6. Batterie rechargeable au lithium tout solide selon l'une quelconque des revendications 1 à 5,
dans laquelle la couche de matériau actif d'électrode négative (4) contient le lithium métallique.

7. Procédé de détermination d'un état de détérioration d'une batterie rechargeable au lithium tout solide, comprenant :
un premier processus de charge et de décharge de la batterie rechargeable au lithium tout solide (10c) selon l'une quelconque des revendications 1 à 6 ;
un deuxième processus de mesure d'une capacité de charge et d'une capacité de décharge de la batterie rechargeable au lithium tout solide (10c) pendant la charge et la décharge ; et
un troisième processus de détermination de l'état de détérioration de la batterie rechargeable au lithium tout solide (10c) à partir d'une relation entre la capacité de décharge et la capacité de charge.

8. Procédé selon la revendication 7,
dans lequel, dans le troisième processus, lorsqu'une différence entre la capacité de décharge et la capacité de charge est égale ou supérieure à une première valeur de seuil ou lorsqu'une proportion entre la capacité de charge par rapport à la capacité de décharge est égale ou inférieure à une seconde valeur de seuil, il est déterminé que la batterie rechargeable au lithium tout solide (10c) s'est détériorée.
